# EUROPÄISCHE PATENTANMELDUNG

(11) **EP 1 968 126 A2**
(43) Veröffentlichungstag der Anmeldung: **10.09.2008**
(21) Anmeldenummer: 08102064.6
(22) Anmeldetag: 27.02.2008
(51) Int. Cl.: H01L 41/053, H01L 41/22

(54) **Verfahren zur Herstellung einer Schutzummantelung für einen Piezoaktor sowie Schutzummantelung für einen Piezoaktor**

(30) Priorität: 08.03.2007 DE 102007011314
(71) Anmelder: Robert Bosch GmbH, 70442 Stuttgart (DE)
(72) Erfinder: Heinz, Rudolf, 71272 Renningen (DE); Dirscherl, Florian, 96049 Bamberg (DE); Schaich, Udo, 70378 Stuttgart (DE)

(57) **Zusammenfassung**

Es wird ein Verfahren zur Herstellung einer einen Piezoaktor (5) zumindest teilweise umhüllenden Schutzummantelung (8) in Form eines mehrlagigen Schichtsystemverbands (10) beschrieben, bei dem in einem ersten Fertigungsschritt eine streifenförmige Schichtsystemeinheit (21) hergestellt wird, indem ein in seiner Länge einem Vielfachen des Umfangs des Piezoaktors (5) und in seiner Breite der Länge des zu umhüllenden Teils des Piezoaktors (5) entsprechender, streifenförmiger Grundträger (17) aus einem ersten Schichtwerkstoff mit mindestens einer mindestens einen zweiten Schichtwerkstoff (19, 20) umfassenden Beschichtung (18) versehen wird, und in einem zweiten, von dem ersten Fertigungsschritt unabhängigen, zeitlich und räumlich getrennt ausführbaren Fertigungsschritt in Form eines Wickelprozesses die Schichtsystemeinheit (21) mehrfach um den Piezoaktor (5) gewickelt wird, um eine Schutzummantelung (8) in Form eines mehrlagigen Schichtsystemverbands (10) zu erhalten. Darüber hinaus wird eine nach einem solchen Verfahren hergestellte Schutzummantelung (8) beschrieben.

## Beschreibung

### Stand der Technik

Die Erfindung betrifft ein Verfahren zur Herstellung einer Schutzummantelung für einen beispielsweise von flüssigen Medien umströmten Piezoaktor in Form eines mehrlagigen Schichtsystemverbands nach den gattungsgemäßen Merkmalen des Anspruchs 1, sowie eine Schutzummantelung in Form eines mehrlagigen, einen beispielsweise von flüssigen Medien umströmten Piezoaktor mindestens teilweise umhüllenden Schichtsystemverbands nach den gattungsgemäßen Merkmalen des Anspruchs 16.

Es ist an sich bekannt, dass zum Aufbau eines zuvor erwähnten Piezoaktors oder Piezoaktormoduls Piezoelemente so eingesetzt werden, dass unter Ausnutzung des sogenannten Piezoeffekts eine Steuerung des Nadelhubs eines Ventils oder dergleichen vorgenommen werden kann. Die Piezoelemente sind aus Piezolagen aus einem Material mit einer geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Piezoaktoren werden beispielsweise in Piezoinjektoren eingesetzt, welche zur zeitpunkt- und mengengenauen Dosierung von Kraftstoff in periodisch arbeitenden Verbrennungsmotoren verwendet werden.

Ein Piezoinjektor besteht im Wesentlichen aus einem Haltekörper und einem in dem Haltekörper angeordneten, ein Kopf- und ein Fußteil, sowie zwischen Kopf- und Fußteil angeordnete Piezoelemente umfassenden Piezoaktor. Der Piezoaktor ist mit einer Düsennadel verbunden, sodass durch Anlegen oder Wegnahme einer Spannung an die Piezoelemente eine Düsenöffnung freigegeben oder verschlossen wird.

Bei der so genannten direkten Düsennadelsteuerung wird der Piezoaktor im Haltekörper des Piezoinjektors direkt im Kraftstoff unter Hochdruck betrieben. Ein Piezoinjektor mit direkter Düsennadelsteuerung ist beispielsweise aus EP 117 46 15 A2 bekannt.

Zum Schutz des Piezoaktors bzw. der Piezoelemente vor Feuchtigkeit, etwa vor Diesel, Wasser, Raps-Methyl-Ester oder sonstigen elektrisch leitenden Substanzen, vor Partikeln und Schwebstoffen, vor den umgebenden hohen Drücken, sowie vor Druck- und Temperaturschwankungen ist es bekannt, den Piezoaktor in einem Piezoinjektor mit direkter Düsennadelsteuerung zumindest teilweise mit einer Schutzummantelung zu versehen.

Zum Einsatz kommt hier vorzugsweise eine Schutzummantelung in Form eines mehrlagigen Schichtsystemverbands. Jede Schicht erfüllt dabei eine spezielle Funktion. Ein polymerer Werkstoff, der unter anderem als eine innerste Schicht vorgesehen ist, verhindert durch seine gute Haftfestigkeit als elektrischer Isolator und Feuchtigkeitssperre Überschläge auf der Oberfläche des Piezoaktors. Eine darauf folgende Schicht aus isolierendem Kunststoff dient als zusätzliche elektrisch isolierende Schicht. Über der Schicht aus isolierendem Kunststoff ist eine zweite Schicht aus polymerem Werkstoff angeordnet. Daraufhin folgen von innen nach außen eine erste Schicht aus einer metallischen Folie, eine dritte Schicht aus polymerem Werkstoff und eine zweite Schicht aus metallischer Folie. Die Schicht aus isolierendem Kunststoff die zwischen den ersten beiden Schichten aus polymerem Werkstoff angeordnet ist, dient als zusätzliche elektrisch isolierende Schicht zu der metallischen Folie. Die Schichten aus polymerem Werkstoff zwischen den Schichten aus isolierendem Kunststoff und metallischen Folien dienen als Gleit- und Hochdruckstütz-Medium sowie als Feuchtigkeitssperre.

Die einzelnen Schichten des mehrlagigen Schichtsystemverbands werden nach dem Stand der Technik einzeln, nacheinander und jeweils für sich in Einzelschritten ausgeführt und aufgetragen oder aufgewickelt, je nach Werkstoff der jeweiligen Schicht.

Nachteilig hieran sind ein hoher technischer Aufwand, lange Prozesszeiten, ein hohes Fertigungsrisiko bedingt durch eine hohe Ausschussquote sowie damit verbundene hohe Kosten für das fertige Produkt.

Die langen Prozesszeiten sind dadurch begründet, dass beispielsweise zwischen den einzelnen Fertigungsschritten, in denen jeweils eine Schicht ausgeführt wird, Wärme- und Abkühlprozesse geschaltet sind, welche nicht umgangen oder zusammengefasst werden können, da für den Schichtsystemverband sonst die geforderten Schichtdicken und die damit verbundenen Isolationsstrecken nicht eingehalten werden können, bzw. die Fertigungseinrichtungen stark verschmutzt werden. Weiterhin müssen die Zwischenprodukte für jeden Fertigungsschritt neu ausgerichtet, positioniert und aufgenommen werden. Anlagen- und fertigungstechnisch ist dies mit hohen Investitions-, Fertigungs- und Wartungskosten verbunden, wodurch die Wertschöpfung eingeschränkt wird.

Darüber hinaus ist eine Prüfung der Schichtdicke des polymeren Werkstoffes bei einer Herstellung nach dem Stand der Technik nicht möglich, da der polymere Werkstoff während des Wickelns eingebracht und anschließend ausgehärtet wird. Blasen und unterschiedliche Schichtdicken, welche beim Wickelprozess und durch einen als Zahnpastatubeneffekt bezeichneten Vorgang des Herausdrückens des Materials entstehen, können am Ende des Prozesses nicht mehr ermittelt werden.

### Offenbarung der Erfindung

Ein erster Gegenstand der Erfindung betrifft ein Verfahren zur Herstellung einer einen Piezoaktor zumindest teilweise umhüllenden Schutzummantelung in Form eines mehrlagigen Schichtsystemverbands. Das erfindungsgemäße Verfahren sieht vor, dass in einem ersten Fertigungsschritt eine streifenförmige Schichtsystemeinheit hergestellt wird, indem ein in seiner Länge einem Vielfachen des Umfangs des Piezoaktors und in seiner Breite der Länge des zu umhüllenden Teils des Piezoaktors entsprechender, streifenförmiger Grundträger aus einem ersten Schichtwerkstoff mit mindestens einer mindestens einen zweiten Schichtwerkstoff umfassenden Beschichtung versehen wird.

In einem zweiten, von dem ersten Fertigungsschritt unabhängigen, zeitlich und räumlich getrennt ausführbaren Fertigungsschritt in Form eines Wickelprozesses wird die im ersten Fertigungsschritt hergestellte Schichtsystemeinheit mehrfach um den eine Wickelachse bildenden Piezoaktor gewickelt, um eine Schutzummantelung in Form eines mehrlagigen Schichtsystemverbands zu erhalten.

Das erfindungsgemäße Verfahren weist gegenüber dem Stand der Technik den Vorteil einer kostengünstigen und einfachen Herstellung einer über die gesamte Lebensdauer eines Piezoinjektors hinweg dauerhaft abdichtenden, bzw. ein das Eindringen von piezoaktorschädigenden Substanzen dauerhaft verhindernden Schutzummantelung in Form eines mehrlagigen Schichtsystemverbands auf. Ein wesentlicher Vorteil des erfindungsgemäßen Verfahrens ergibt sich durch die getrennte Herstellbarkeit der Schichtsystemeinheit in einem eigenen Fertigungsschritt. Die Schichtsystemeinheit kann so getrennt vom Wickelprozess, in dem die eigentliche Herstellung des Schichtsystemverbands durch Umwickeln des Piezoaktors mit der Schichtsystemeinheit erfolgt, hergestellt werden. Dabei können ein oder mehrere separate Beschichtungsprozesse, in denen die Schichtsystemeinheit durch Beschichten des streifenförmigen Grundträgers hergestellt wird, dem Wickelprozess vorgeschaltet werden. Hierbei können Fertigungseinrichtungen, beispielsweise durch Fertigungsschleifen oder durch eine Doppelnutzung von Peripherien, optimal mehrfach genutzt und beispielsweise räumlich, zeitlich und energetisch aufeinander abgestimmt werden, ohne auf den bisherigen Fertigungsfluss Rücksicht nehmen zu müssen.

Ein zusätzlicher Vorteil des erfindungsgemäßen Verfahrens ist, dass bei der Herstellung der Schichtsystemeinheit keine speziellen Vorsichtsmaßnahmen in Bezug auf die Baugruppe des Piezoaktors bzw. des Piezoaktormoduls beispielsweise in Bezug auf Feuchtigkeit, Prozesstemperaturen, Fertigungshilfsstoffe, mechanische Beschädigung von Anbindeteilen und dergleichen getroffen werden müssen, da diese erst am Ende der Prozesskette, zum Wickelprozess, eingebracht werden. Darüber hinaus ist durch die getrennte Herstellung der Schichtsystemeinheit als weiterer Vorteil eine räumliche und zeitliche Trennung vom eigentlichen Wickelprozess möglich, was beispielsweise eine Herstellung des kompakten Schichtsystems an einer von der Fertigungsstätte für die Piezoaktoren entfernten Fertigungsstätte erlaubt.

Ein weiterer Vorteil des erfindungsgemäßen Verfahrens ist, dass die Beschichtung gleichmäßig in konstanter Dicke ohne Fehlstellen aufgebracht und auf einfache Weise flächig kontrolliert werden kann. Auch hier können beispielsweise optische Prüfeinrichtungen mehrfach genutzt oder zusammengefasst werden.

Außerdem ergibt sich ein Vorteil des erfindungsgemäßen Verfahrens dadurch, dass der Piezoaktor und die in einem eigenen Fertigungsschritt hergestellte Schichtsystemeinheit nur noch einmal zum Wickelprozess zueinander ausgerichtet werden müssen. Nach dem Stand der Technik hat eine solche Ausrichtung je Schicht zu erfolgen. Beim erfindungsgemäßen Verfahren muss der Wickelprozess dann ebenfalls nur noch einmalig gestartet werden, anstatt der bisherigen mindestens drei Prozessabläufe. Auch hieraus ergeben sich hohe Einsparungen im Bereich Investitions-, Fertigungs- und Wartungskosten, was eine deutlich höhere Wertschöpfung nach sich zieht.

Eine vorteilhafte Ausgestaltung des erfindungsgemäßen Verfahrens sieht vor, dass die streifenförmige Schichtsystemeinheit während des Wickelprozesses zunächst mindestens im Bereich eines durch eine parallel zu einer im Wickelprozess durch den Piezoaktor gebildeten Wickelachse verlaufende erste Schmalseite des streifenförmigen Grundkörpers gebildeten ersten Endes am Piezoaktor befestigt und anschließend um den Piezoaktor gewickelt wird. Durch das Befestigen eines ersten Endes der Schichtsystemeinheit am Piezoaktor wird der Wickelprozess vereinfacht.

Ebenso ist denkbar, dass die Schichtsystemeinheit während des Wickelprozesses im Bereich eines durch eine erste Umwicklung mit dem Piezoaktor unmittelbar in Kontakt stehenden Abschnitts am Piezoaktor befestigt wird. Hierdurch wird eine verbesserte Verbindung zwischen Piezoaktor und Schichtsystemverbund erreicht, wodurch das Eindringen von flüssigen Substanzen und Verunreinigungen nachhaltiger verhindert wird.

Das Befestigen der Schichtsystemeinheit am Piezoaktor kann beispielsweise durch Kleben oder Löten erfolgen. Beim Kleben oder Löten handelt es sich um erprobte und damit prozesssichere Befestigungsverfahren.

Vorzugsweise ist die auf dem streifenförmigen Grundträger angeordnete Beschichtung mindestens in einer senkrecht zu einer im Wickelprozess durch den Piezoaktor gebildeten Wickelachse verlaufenden Längsrichtung des streifenförmigen Grundträgers mindestens abschnittsweise aus unterschiedlichen Schichtwerkstoffen hergestellt. Da bei dem erfindungsgemäßen Verfahren die Schutzummantelung in Form eines mehrlagigen Schichtsystemverbands durch Wickeln hergestellt wird, wodurch in einem senkrecht zum Piezoaktor verlaufenden Querschnitt eine schneckenförmige Struktur entsteht, kann durch eine in Längsrichtung des streifenförmigen Grundkörpers zumindest abschnittsweise aus unterschiedlichen Schichtwerkstoffen hergestellte Beschichtung ein mehrlagiger Schichtsystemverband hergestellt werden, der aus unterschiedlichen Schichtwerkstoffen besteht. Ein sich hieraus ergebender Vorteil ist, dass mit nur einem Systemelement in Form eines abschnittsweise mit unterschiedlichen Schichtwerkstoffen beschichteten streifenförmigen Grundträgers alle zum Schutz eines Piezoaktors erforderlichen Schichten des mehrlagigen Schichtverbands aufgebracht werden können. In einem zwischen angrenzenden Schichtwerkstoffen der Beschichtung liegenden Übergangsbereich werden die Schichtwerkstoffe vorzugsweise mechanisch und hochdruckdicht miteinander verbunden. Diese Verbindung kann beispielsweise durch Vulkanisieren, Kleben oder auf andere geeignete Art und Weise hergestellt werden.

Dabei entsprechen die Abmessungen der durch die unterschiedlichen Schichtwerkstoffe gebildeten Abschnitte in Längsrichtung des streifenförmigen Grundträgers vorzugsweise jeweils im Wesentlichen einem ganzzahligen Vielfachen des Umfangs des Piezoaktors bzw. einem ganzzahligen Vielfachen von Umwicklungen des Piezoaktors. Damit wird sichergestellt, dass jeder Schichtwerkstoff eine den Piezoaktor zumindest einmal umhüllende Schicht bildet.

Eine andere vorteilhafte Ausgestaltung des erfindungsgemäßen Verfahrens sieht vor, dass die auf dem streifenförmigen Grundträger angeordnete Beschichtung mindestens in einer parallel zu einer im Wickelprozess durch den Piezoaktor gebildeten Wickelachse verlaufenden Querrichtung des streifenförmigen Grundträgers mindestens abschnittsweise aus unterschiedlichen Schichtwerkstoffen hergestellt ist. Hierdurch können beispielsweise im Bereich der Ränder des Schichtsystemverbandes, die bei einem mit der fertigen Schutzummantelung versehenen Piezoaktor im Bereich des Aktorkopfes und des Aktorfußes liegen, andere Schichtwerkstoffe verwendet werden, als in dem zwischen Aktorkopf und Aktorfuß liegenden Bereich, der wesentlich zum Schutz des Piezoaktors dient.

Die Beschichtung des streifenförmigen Grundträgers kann beispielsweise hergestellt werden, indem zunächst ein zweiter Schichtwerkstoff partiell in Form einer Umrandung auf den streifenförmigen Grundträger aufgebracht, und anschließend innerhalb eines durch die Umrandung abgegrenzten Bereichs mindestens ein dritter Schichtwerkstoff angeordnet wird. Hierdurch können beispielsweise Schichtwerkstoffe aneinandergefügt werden, welche sich im flüssigen Zustand vermischen und dadurch ihre Eigenschaften bzw. Funktionen verlieren würden. Beispielsweise können während des ersten Fertigungsschritts in einem ersten Schritt eine Klebeschicht oder eine Lotschicht als Umrandung aufgetragen oder angeliert bzw. ausgehärtet werden, und in einem Folgeschritt ein flüssiges Polymer innerhalb der Umrandung verfüllt und ebenfalls ausgehärtet werden. Die jeweiligen Prozessparameter sind dabei selbstverständlich aufeinander abzustimmen.

Die Abmessungen der durch die unterschiedlichen Schichtwerkstoffe gebildeten Abschnitte in Längsrichtung des streifenförmigen Grundträgers innerhalb des durch die Umrandung abgegrenzten Bereichs entsprechen dabei vorzugsweise jeweils im Wesentlichen einem ganzzahligen Vielfachen des Umfangs des Piezoaktors bzw. einem ganzzahligen Vielfachen von Umwicklungen des Piezoaktors. Damit wird sichergestellt, dass jeder Schichtwerkstoff eine den Piezoaktor zumindest einmal umhüllende Schicht bildet.

Gemäß einer vorteilhaften Ausgestaltung des erfindungsgemäßen Verfahrens ist vorgesehen, dass zumindest ein Teil des durch die Umrandung abgegrenzten Bereichs während des ersten Fertigungsschritts mit mindestens einem dritten, zunächst flüssigen Schichtwerkstoff verfüllt wird, der dann innerhalb der Umrandung in eine feste Form übergeht.

Eine besonders vorteilhafte Ausgestaltung des erfindungsgemäßen Verfahrens sieht vor, dass zumindest abschnittsweise mindestens ein Schichtwerkstoff der Beschichtung den darunter liegenden streifenförmigen Grundkörper überragt. Im Gegensatz zum Stand der Technik erlaubt das erfindungsgemäße Verfahren ein Maskieren und partielles Auftragen der einzelnen Schichtwerkstoffe auf den streifenförmigen Grundkörper, auch in der Weise, dass die Beschichtung zumindest abschnittsweise den streifenförmigen Grundkörper beispielsweise in dessen Breite überragt. Ebenso ist denkbar, dass ein Schichtwerkstoff der Beschichtung den streifenförmigen Grundträger im Bereich eines oder beider seiner beiden Enden, entsprechend in seiner Länge überragt.

Die in dem ersten Fertigungsprozess hergestellte Schichtsystemeinheit kann vor dem Wickelprozess zumindest teilweise mit einem Klebstoff und/oder mit einem Lot versehen werden, um die Schichtsystemeinheit beim ersten Umwickeln beispielsweise im Bereich der Ränder oder vollflächig mit dem Piezoaktor zu verbinden, und um in den nachfolgenden Umwicklungen eine Verbindung zu den durch vorherige Umwicklungen hergestellten Schichten herzustellen.

Der Schichtwerkstoff des Grundträgers ist vorzugsweise ein polymerer Werkstoff, vorzugsweise ein Ethylen/Propylen-Copolymer. Ein Schichtwerkstoff der Beschichtung des Grundträgers umfasst vorzugsweise einen isolierenden Kunststoff, vorzugsweise Kaplon oder Polyphenylensulfid. Ein Schichtwerkstoff der Beschichtung des Grundträgers kann auch eine metallische Folie umfassen.

Ein zweiter Gegenstand der Erfindung betrifft eine Schutzummantelung in Form eines mehrlagigen, einen Piezoaktor mindestens teilweise umhüllenden Schichtsystemverbands. Die Schutzummantelung umfasst mindestens eine in einem senkrecht zu einer durch den Piezoaktor gebildeten Wickelachse verlaufenden Querschnitt von innen nach außen schneckenförmig mehrfach um den Piezoaktor gewickelten, mit einer Beschichtung versehenen streifenförmigen Grundträger aus einem ersten Schichtwerkstoff, welcher in radialer Richtung durch dazwischenliegende Schichten aus mindestens einem zweiten Schichtwerkstoff getrennte Schichten des mehrlagigen Schichtsystemverbands bildet, wobei die dazwischen liegenden Schichten aus mindestens einem zweiten Schichtwerkstoff durch die Beschichtung des Grundträgers gebildet werden, welche sich je Schichtwerkstoff mindestens über eine ganze Umwicklung erstreckt.

Die erfindungsgemäße Schutzummantelung weist gegenüber dem Stand der Technik den Vorteil auf, dass sie kostengünstig und einfach hergestellt werden kann und eine über die gesamte Lebensdauer eines Piezoinjektors hinweg dauerhafte Abdichtung bewirkt, bzw. ein Eindringen von piezoaktorschädigenden Substanzen dauerhaft verhindert. Die nach einem zuvor beschriebenen Verfahren herstellbare erfindungsgemäße Schutzummantelung erlaubt darüber hinaus sämtliche durch das Verfahren erzielbaren Vorteile in Bezug auf Herstellung und Kosten zu nutzen.

Ein Ausführungsbeispiel der Erfindung wird im Folgenden näher beschrieben. Es zeigen:
- Fig. 1: eine schematische Darstellung eines Piezoinjektors in einem Längsschnitt,
- Fig. 2: eine schematische Darstellung einer erfindungsgemäßen Schutzummantelung in Form eines mehrlagigen Schichtsystemverbunds in einem parallel zur Längsachse eines Piezoaktors verlaufenden Querschnitt,
- Fig.3: eine schematische Darstellung eines senkrecht zu einer durch einen Piezoaktor gebildeten Wickelachse verlaufenden Querschnitts durch eine erfindungsgemäße Schutzummantelung in Form eines mehrlagigen Schichtsystemverbands,
- Fig. 4: eine schematische Darstellung eines Teils einer aus einem mit einer Beschichtung versehenen streifenförmigen Grundträger bestehenden Schichtsystemeinheit in einer Draufsicht, sowie
- Fig. 5: die Schichtsystemeinheit aus Fig. 4 in einem parallel zur Längsachse des streifenförmigen Grundkörpers verlaufenden Querschnitt.

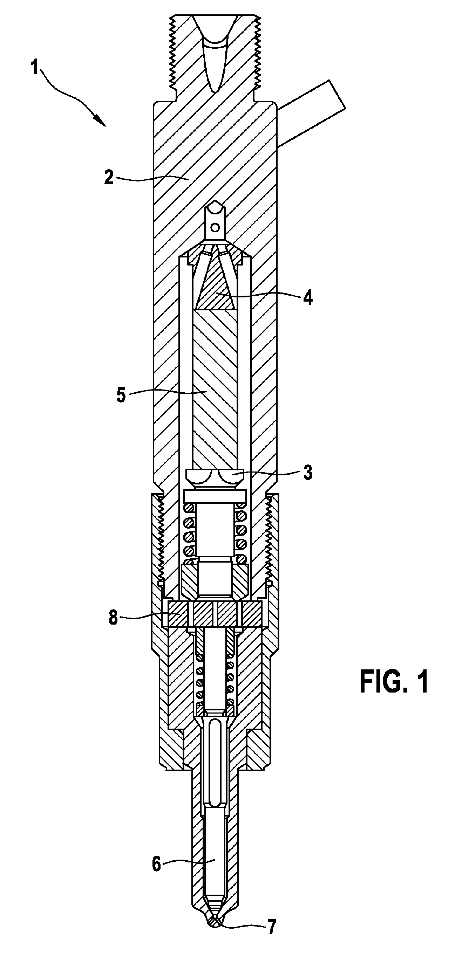

Fig. 1 zeigt einen einstufigen Piezoinjektor 1 mit direkter Nadelsteuerung. Der Piezoinjektor 1 besteht im Wesentlichen aus einem Haltekörper 2 und einem in dem Haltekörper 2 angeordneten, einen Aktorkopf 3 und einen Aktorfuß 4 sowie zwischen Aktorkopf 3 und Aktorfuß angeordnete Piezoelemente umfassenden Piezoaktor 5. Die Piezoelemente sind aus Piezolagen aus einem Material mit einer geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt. Der Piezoaktor 5 ist mit einer Düsennadel 6 verbunden, sodass durch Anlegen oder Wegnahme einer Spannung an das Piezoelement eine Düsenöffnung 7 freigegeben oder verschlossen wird. Bei der direkten Nadelsteuerung ist zwischen Piezoaktor 5 und Düsennadel 6 lediglich ein Koppler 8 mit hydraulischer Übersetzung angeordnet. Die Düsennadel 6 folgt übersetzt direkt der Bewegung des Piezoaktors 5.

Zum Schutz des Piezoaktors 5 bzw. der Piezoelemente vor Feuchtigkeit, etwa vor Diesel, Wasser, Raps-Methyl-Ester oder sonstigen elektrisch leitenden Substanzen, vor Partikeln und Schwebstoffen, vor den umgebenden hohen Drücken, sowie vor Druck- und Temperaturschwankungen, ist der Piezoaktor 5 im Piezoinjektor 1 mit direkter Nadelsteuerung mit einer Schutzummantelung versehen.

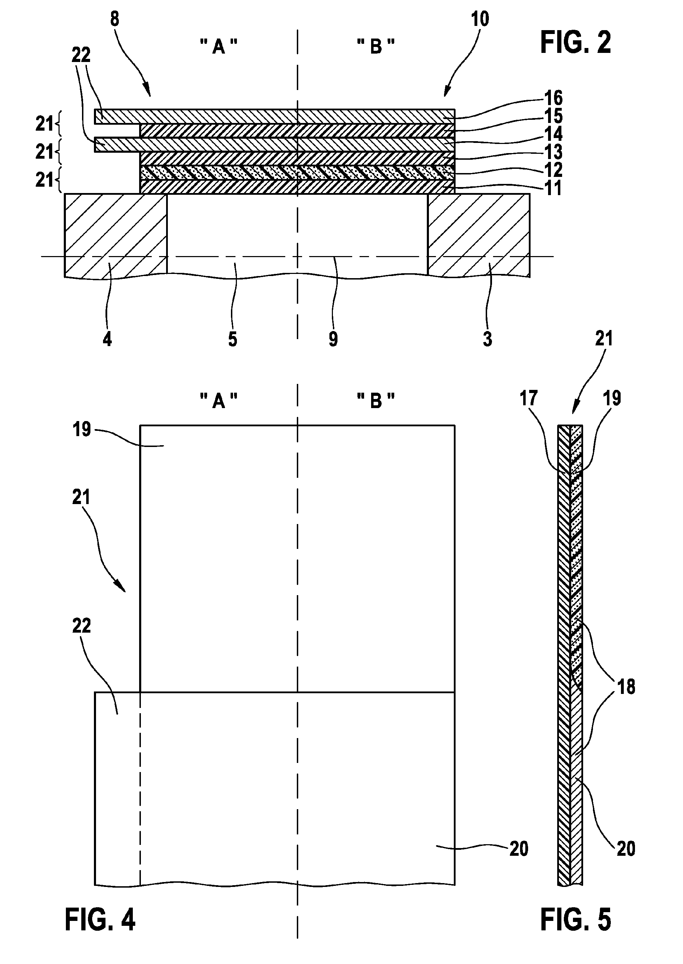

Fig. 2 zeigt einen schematischen Querschnitt durch eine erfindungsgemäße Schutzummantelung 8. Der Querschnitt ist in Längsrichtung des Piezoaktors 5 durch dessen Längsachse 9 hindurch ausgeführt. Die Schutzummantelung 8 ist in Form eines mehrlagigen Schichtsystemverbands 10 ausgeführt. Jede Schicht 11, 12, 13, 14, 15, 16 des Schichtsystemverbands 10 erfüllt dabei eine spezielle Funktion. Ein polymerer Werkstoff, der unter anderem als eine innerste Schicht 11 vorgesehen ist, verhindert durch seine gute Haftfestigkeit als elektrischer Isolator und Feuchtigkeitssperre Überschläge auf der Oberfläche des Piezoaktors. Eine darauf folgende Schicht 12 aus isolierendem Kunststoff dient als zusätzliche elektrisch isolierende Schicht. Über der Schicht 12 aus isolierendem Kunststoff ist eine zweite Schicht 13 aus polymerem Werkstoff angeordnet. Daraufhin folgen von innen nach außen eine erste Schicht 14 aus einer metallischen Folie, eine dritte Schicht 15 aus polymerem Werkstoff und eine zweite Schicht 16 aus metallischer Folie. Die Schicht 12 aus isolierendem Kunststoff die zwischen den ersten beiden Schichten 11, 13 aus polymerem Werkstoff angeordnet ist, dient als zusätzliche elektrisch isolierende Schicht zu der ersten Schicht 14 aus metallischer Folie. Die Schichten 13, 15 aus polymerem Werkstoff zwischen der Schicht 12 aus isolierendem Kunststoff und den metallischen Folien 14, 16 dienen als Gleit- und Hochdruckstütz-Medium sowie als Feuchtigkeitssperre.

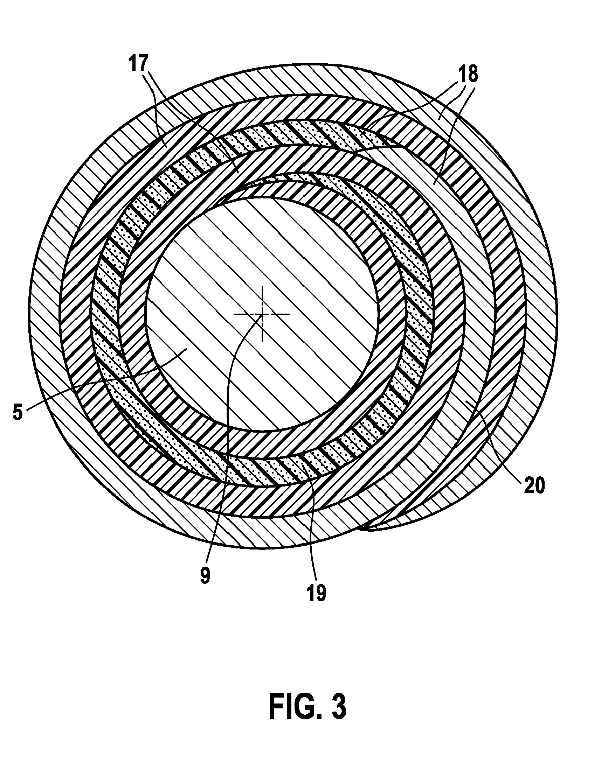

Der Aufbau der erfindungsgemäßen Schutzummantelung 8 kann Fig. 3 entnommen werden. Fig. 3 zeigt hierzu einen Querschnitt durch eine erfindungsgemäße Schutzummantelung 8, in einer Richtung normal zur Längsachse 9 des Piezoaktors 5. Die Schutzummantelung 8 umfasst mindestens einen in dem senkrecht zu einer durch den Piezoaktor 5 bzw. dessen Längsachse 9 gebildeten Wickelachse verlaufenden Querschnitt von innen nach außen schneckenförmig mehrfach um den Piezoaktor 5 gewickelten streifenförmigen Grundträger 17 aus einem ersten Schichtwerkstoff. Der streifenförmige Grundträger 17 besteht aus einem polymeren Werkstoff, etwa aus einem Ethylen/Propylen-Copolymer. Durch das mehrfache Umwickeln des Piezoaktors 5 bildet der streifenförmige Grundträger 17 in dem in Fig. 2 gezeigten Querschnitt in radialer Richtung die Schichten 11, 13, 15. Der streifenförmige Grundträger 17 ist mit einer Beschichtung 18 versehen, welche abschnittsweise aus einem zweiten 19 und einem dritten Schichtwerkstoff 20 besteht. Der zweite Schichtwerkstoff 19 der Beschichtung 18 des Grundträgers 17 umfasst vorzugsweise einen isolierenden Kunststoff, vorzugsweise Kaplon oder Polyphenylensulfid. Der dritte Schichtwerkstoff 20 der Beschichtung 18 des Grundträgers 17 umfasst eine metallische Folie. Die zwischen den durch den streifenförmigen Grundträger 17 gebildeten Schichten 11, 13, 15 liegenden Schichten 12, 14, 16 aus dem zweiten 19 und dem dritten Schichtwerkstoff 20 werden durch die Beschichtung 18 des Grundträgers 17 gebildet. Die Beschichtung 18 erstreckt sich je Schichtwerkstoff 19, 20 mindestens über eine ganze Umwicklung des Piezoaktors 5.

Die den Piezoaktor 5 zumindest teilweise umhüllende Schutzummantelung 8 in Form eines mehrlagigen Schichtsystemverbands 10 wird hergestellt, indem in einem ersten Fertigungsschritt eine in den Fig. 4 und 5 gezeigte streifenförmige Schichtsystemeinheit 21 hergestellt wird. Hierzu wird der in seiner Länge einem Vielfachen des Umfangs des Piezoaktors 5 und in seiner Breite der Länge des zu umhüllenden Teils des Piezoaktors 5 entsprechender, streifenförmiger Grundträger 17 aus einem ersten Schichtwerkstoff mit einer den zweiten Schichtwerkstoff 19 und den dritten Schichtwerkstoff 20 umfassenden Beschichtung 18 versehen. Dies kann in einem einzigen oder in zwei getrennten Verfahrensschritten erfolgen. In einem zweiten, von dem ersten Fertigungsschritt unabhängigen, zeitlich und räumlich getrennt ausführbaren Fertigungsschritt in Form eines Wickelprozesses wird die im ersten Fertigungsschritt hergestellte Schichtsystemeinheit 21 mehrfach um den mit seiner Längsachse 9 eine Wickelachse bildenden Piezoaktor 5 gewickelt wird, um eine Schutzummantelung 8 in Form eines mehrlagigen Schichtsystemverbands 10 zu erhalten.

Die auf dem streifenförmigen Grundträger 17 angeordnete Beschichtung 18 ist hierbei in einer senkrecht zu einer im Wickelprozess durch den Piezoaktor 5 gebildeten Wickelachse verlaufenden Längsrichtung des streifenförmigen Grundträgers 17 abschnittsweise aus unterschiedlichen Schichtwerkstoffen hergestellt. Jeder der Abschnitte ist mindestens so lang, wie eine Umwicklung des Piezoaktors 5. Zusätzlich kann die auf dem streifenförmigen Grundträger 17 angeordnete Beschichtung mindestens in einer parallel zu einer im Wickelprozess durch den Piezoaktor 5 gebildeten Wickelachse verlaufenden Querrichtung des streifenförmigen Grundträgers 17 mindestens abschnittsweise aus unterschiedlichen Schichtwerkstoffen hergestellt sein. Hierdurch können beispielsweise im Bereich der Ränder des Schichtsystemverbandes 10, die bei einem mit der fertigen Schutzummantelung versehenen Piezoaktor im Bereich des Aktorkopfes 3 und/oder des Aktorfußes 4 liegen, andere Schichtwerkstoffe verwendet werden, als in dem zwischen Aktorkopf 3 und Aktorfuß 4 liegenden Bereich.

Eine links in den Fig. 2 und 4 gezeigte Variante A zeigt maskierte bzw. teilbeschichtete Bereiche des streifenförmigen Grundträgers 17. Dabei ragen die metallischen Folien, welche als dritter Schichtwerkstoff 20 auf den streifenförmigen Grundträger 17 aufgebracht sind, in einem Bereich 22 der dem Aktorfuß 4 und dem Aktorkopf 3 zugewandten Ränder über den streifenförmigen Grundkörper 17 über. Variante B, rechts in den Fig. 2 und 4, zeigt einen vollbedruckten bzw. vollbeschichteten streifenförmigen Grundträger 17.

Wichtig ist hervorzuheben, dass die Erfindung nicht nur für einen in Fig. 1 dargestellten Piezoinjektor 1 mit einem Koppler 8 mit einstufiger Übersetzung, sondern auch für einen Piezoinjektor mit einem Koppler mit zweistufiger Übersetzung angewandt werden kann.

## Patentansprüche

1. Verfahren zur Herstellung einer einen Piezoaktor (5) zumindest teilweise umhüllenden Schutzummantelung (8) in Form eines mehrlagigen Schichtsystemverbands (10), **dadurch gekennzeichnet, dass** in einem ersten Fertigungsschritt eine streifenförmige Schichtsystemeinheit (21) hergestellt wird, indem ein in seiner Länge einem Vielfachen des Umfangs des Piezoaktors (5) und in seiner Breite der Länge des zu umhüllenden Teils des Piezoaktors (5) entsprechender, streifenförmiger Grundträger (17) aus einem ersten Schichtwerkstoff mit mindestens einer mindestens einen zweiten Schichtwerkstoff (19, 20) umfassenden Beschichtung (18) versehen wird, und in einem zweiten, von dem ersten Fertigungsschritt unabhängigen, zeitlich und räumlich getrennt ausführbaren Fertigungsschritt in Form eines Wickelprozesses die Schichtsystemeinheit (21) mehrfach um den Piezoaktor (5) gewickelt wird, um eine Schutzummantelung (8) in Form eines mehrlagigen Schichtsystemverbands (10) zu erhalten.

2. Verfahren nach Anspruch 1, **dadurch gekennzeichnet, dass** die streifenförmige Schichtsystemeinheit (21) während des Wickelprozesses zunächst mindestens im Bereich eines durch eine erste Schmalseite des streifenförmigen Grundkörpers (17) gebildeten ersten Endes am Piezoaktor (5) befestigt und anschließend um den Piezoaktor (5) gewickelt wird.

3. Verfahren nach Anspruch 1 oder 2, **dadurch gekennzeichnet, dass** die Schichtsystemeinheit (21) während des Wickelprozesses im Bereich eines durch eine erste Umwicklung mit dem Piezoaktor (5) unmittelbar in Kontakt stehenden Abschnitts am Piezoaktor (5) befestigt wird.

4. Verfahren nach Anspruch 2 oder 3, **dadurch gekennzeichnet, dass** das Befestigen der Schichtsystemeinheit (21) am Piezoaktor (5) durch Kleben oder Löten erfolgt.

5. Verfahren nach einem der vorhergehenden Ansprüche, **dadurch gekennzeichnet, dass** die auf dem streifenförmigen Grundträger (17) angeordnete Beschichtung (18) mindestens in einer Längsrichtung des streifenförmigen Grundträgers (17) mindestens abschnittsweise aus unterschiedlichen Schichtwerkstoffen (19, 20) hergestellt ist.

6. Verfahren nach Anspruch 5, **dadurch gekennzeichnet, dass** die Abmessungen der durch die unterschiedlichen Schichtwerkstoffe (19, 20) gebildeten Abschnitte in Längsrichtung des streifenförmigen Grundträgers (17) jeweils im Wesentlichen einem ganzzahligen Vielfachen des Umfangs des Piezoaktors (5) entsprechen.

7. Verfahren nach einem der vorhergehenden Ansprüche, **dadurch gekennzeichnet, dass** die auf dem streifenförmigen Grundträger (17) angeordnete Beschichtung (18) mindestens in einer Querrichtung des streifenförmigen Grundträgers (17) mindestens abschnittsweise aus unterschiedlichen Schichtwerkstoffen (19, 20) hergestellt ist.

8. Verfahren Anspruch 5 oder 7, **dadurch gekennzeichnet, dass** die Beschichtung (18) des streifenförmigen Grundträgers (17) hergestellt wird, indem zunächst ein zweiter Schichtwerkstoff (19) partiell in Form einer Umrandung auf den streifenförmigen Grundträger aufgebracht, und anschließend innerhalb eines durch die Umrandung abgegrenzten Bereichs mindestens ein dritter Schichtwerkstoff (20) angeordnet wird.

9. Verfahren nach Anspruch 8, **dadurch gekennzeichnet, dass** die Abmessungen der durch die unterschiedlichen Schichtwerkstoffe (19, 20) gebildeten Abschnitte in Längsrichtung des streifenförmigen Grundträgers (17) innerhalb des durch die Umrandung abgegrenzten Bereichs jeweils im Wesentlichen einem ganzzahligen Vielfachen des Umfangs des Piezoaktors (5) entsprechen.

10. Verfahren nach Anspruch 8 oder 9, **dadurch gekennzeichnet, dass** zumindest ein Teil des durch die Umrandung abgegrenzten Bereichs während des ersten Fertigungsschritts mit mindestens einem dritten, zunächst flüssigen Schichtwerkstoff verfüllt wird, der dann innerhalb der Umrandung in eine feste Form übergeht.

11. Verfahren nach einem der vorhergehenden Ansprüche, **dadurch gekennzeichnet, dass** zumindest abschnittsweise (22) mindestens ein Schichtwerkstoff (20) der Beschichtung (18) den darunter liegenden streifenförmigen Grundkörper (17) überragt.

12. Verfahren nach einem der vorhergehenden Ansprüche, **dadurch gekennzeichnet, dass** die Schichtsystemeinheit (21) vor dem Wickelprozess zumindest teilweise mit einem Klebstoff und/oder mit einem Lot versehen wird.

13. Verfahren nach einem der vorhergehenden Ansprüche, **dadurch gekennzeichnet, dass** der Schichtwerkstoff des Grundträgers (17) ein polymerer Werkstoff, vorzugsweise ein Ethylen/Propylen-Copolymer ist.

14. Verfahren nach einem der vorhergehenden Ansprüche, **dadurch gekennzeichnet, dass** ein Schichtwerkstoff (19) der Beschichtung (18) des Grundträgers (17) einen isolierenden Kunststoff, vorzugsweise Kaplon oder Polyphenylensulfid umfasst.

15. Verfahren nach einem der vorhergehenden Ansprüche, **dadurch gekennzeichnet, dass** ein Schichtwerkstoff (20) der Beschichtung (18) des Grundträgers (17) eine metallische Folie umfasst.

16. Schutzummantelung (8) in Form eines mehrlagigen, einen Piezoaktor (5) mindestens teilweise umhüllenden Schichtsystemverbands (10), **gekennzeichnet durch** einen in einem senkrecht zu einer **durch** den Piezoaktor (5) gebildeten Wickelachse (9) verlaufenden Querschnitt von innen nach außen schneckenförmig mehrfach um den Piezoaktor (5) gewickelten, mit einer Beschichtung (18) versehenen streifenförmigen Grundträger (17) aus einem ersten Schichtwerkstoff, welcher in radialer Richtung **durch** dazwischenliegende Schichten (12, 14, 16) aus mindestens einem zweiten Schichtwerkstoff (19, 20) getrennte Schichten (11, 13, 15) des mehrlagigen Schichtsystemverbands (10) bildet, wobei die dazwischen liegenden Schichten (12, 14, 16) aus mindestens einem zweiten Schichtwerkstoff (19, 20) **durch** die Beschichtung (18) des Grundträgers (17) gebildet werden, welche sich je Schichtwerkstoff (19, 20) mindestens über eine ganze Umwicklung erstreckt.
